# EUROPEAN PATENT SPECIFICATION

(11) **EP 4 297 068 B1**
(45) Date of publication and mention of the grant of the patent: **11.11.2026**
(21) Application number: 22756010.9
(22) Date of filing: 08.02.2022
(51) Int. Cl.: H10N 30/073, H10N 30/072, H10N 30/80, H10P 14/20

(54) **METHOD FOR PRODUCING A COMPOSITE WAFER**
VERFAHREN ZUR HERSTELLUNG EINES VERBUNDSWAFERS
PROCÉDÉ DE PRODUCTION D'UNE TRANCHE COMPOSITE

(30) Priority: 19.02.2021 JP 2021025398
(43) Date of publication of application: 27.12.2023
(73) Proprietor: SHIN-ETSU CHEMICAL CO., LTD., Tokyo 1000005 (JP)
(72) Inventor: AKIYAMA, Shoji, Annaka-shi, Gunma 379-0195 (JP)
(74) Representative: Pfenning, Meinig & Partner mbB
(86) International application number: PCT/JP2022/004806
(87) International publication number: WO 2022/176689

(56) References cited:
- WO-A1-2009/081651
- WO-A1-2011/065317
- WO-A1-2013/031650
- WO-A1-2013/031651
- WO-A1-2018/088093
- JP-A- 2005 535 555
- JP-A- 2013 046 107
- JP-A- 2015 228 637
- JP-A- 2018 061 226
- JP-A- H0 548 171
- JP-A- H0 786 866
- JP-A- H07 193 294
- US-A1- 2014 055 008
- US-A1- 2019 051 525

## Description

### TECHNICAL FIELD

The present invention relates to a method for producing a composite wafer.

### BACKGROUND

A method of sticking a wafer of lithium tantalate (Lithium Tantalate: may be abbreviated to LT) into which a hydrogen ion is implanted in advance and a wafer of lithium tantalate via a metal film, and performing a thermal treatment, thereby causing delamination with heat while avoiding a problem due to a difference in thermal expansion coefficients, has been known (for example, see Non-Patent Document 1).

Patent Document 1 describes an elastic wave device: using a laminated structure having a piezoelectric film that has lithium tantalate as the main component thereof and a piezoelectric substrate that has lithium niobate as the main component thereof.
An elastic wave device that uses a laminated substrate comprising a plurality of stacked piezoelectric single crystals is known from Patent Document 2. Patent Document 3 concerns a method of manufacturing a piezoelectric device. After an ion implanted portion is formed in a piezoelectric single crystal substrate by implantation of hydrogen ions, an interlayer of a metal is formed on a rear surface of the piezoelectric single crystal substrate. In addition, a support member is bonded to the piezoelectric single crystal substrate with the interlayer interposed there between. A composite piezoelectric body in which the ion implanted portion is formed is heated at about 450° C. to about 700° C. to oxidize the metal of the interlayer. Document D4 discloses a method of manufacturing a composite wafer where the faces of a sapphire wafer and a lithium tantalate wafer to be bonded to each other are subjected to surface activation by plasma treatment under a nitrogen atmosphere.

### PRIOR ART DOCUMENTS

### PATENT DOCUMENTS

Patent Document 1: WO 2013/031651 A1
Patent Document 2: WO 2013/031650 A1
Patent Document 3: US 2014/055008 A1
Patent Document D4: US2019/051525 A1

### NON-PATENT DOCUMENT

Non-Patent Document 1: "3-inch single crystal LiTaO3 films onto metallic electrode using SmartCut™ technology" Tauzin et al. ELECTRIC LETTERS, 19th June 2008, Vol.44 No.13

### PROBLEM TO BE SOLVED

When lithium tantalate or lithium niobate (Lithium Niobate: may be abbreviated to LN) is used for a supporting wafer, a charge is generated also in a thin film LT or LN which is an active layer in accordance with polarization possessed by LT or LN as the supporting wafer, and thus characteristics are negatively affected.

### GENERAL DISCLOSURE

The present invention is defined by the independent method claim 1.

The dependent claims define particular embodiments of the present invention.

The method further comprises forming an interposed layer on at least either of surfaces of the supporting substrate and the active substrate to be stuck to each other is further included before the sticking. The interposed layer may have insulation properties. The interposed layer includes at least one of SiO₂, SiON, or SiN. The interposed layer may be formed by either a PVD method or a CVD method.

The preparing the supporting substrate may include: causing polarization possessed by the supporting substrate in advance to be non-polarized.

### BRIEF DESCRIPTION OF THE DRAWINGS

Fig. 1 schematically illustrates a cross-sectional view of a composite wafer 10 as an example not forming part of the invention.
Fig. 2 schematically illustrates each step of a method for producing the composite wafer 10.
Fig. 3 illustrates a relationship between a supporting substrate and a destruction temperature.
Fig. 4 illustrates a relationship between the supporting substrate and a Qmax value.

### DESCRIPTION OF EXEMPLARY EMBODIMENTS

Hereinafter, the present invention will be described through embodiments of the invention, but the following embodiments do not limit the invention according to claims. In addition, not all of the combinations of features described in the embodiments are essential to the solution of the invention.

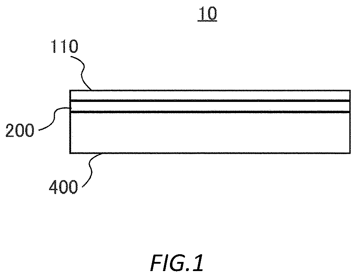

Fig. 1 schematically illustrates a cross-sectional view of a composite wafer 10 not forming part of the invention. The composite wafer 10 includes an LT substrate 400 as a supporting substrate, an interposed layer 200 which is disposed on one surface of the LT substrate 400, and an LT layer 110 as an active layer which is disposed on an opposite surface of the interposed layer 200 from the LT substrate 400.

The LT layer 110 is polarized. For example, the LT layer 110 is a single crystal, and is electrically polarized in a Z-axis direction of the crystal even without an external electric field. In this manner, the LT layer 110 is formed as an active layer which exerts a function such as a piezoelectric effect.

The LT layer 110 has a thickness of several hundred nm, for example. An LN layer may be used instead of the LT layer 110.

On the other hand, the LT substrate 400 is not substantially polarized. A state of not being substantially polarized herein is weaker than at least the polarization of the LT layer 110, and it includes not only a state in which polarization is not caused at all when there is no external electric field, but also a state in which polarization is not intentionally caused but was originally caused, a state in which polarization is remained even after going through a process of eliminating the polarization, a state in which polarization is caused in a level that does not affect exertion of the function of the LT layer 110, and the like. Furthermore, for example, the polarization of the LT substrate 400 is preferably 0.5 pC/N or less in an absolute value of a d33 meter.

The LT substrate 400 has a thickness of several hundred µm, for example, and it gives a mechanical strength when handling the composite wafer 10. Instead of the LT substrate 400, another substrate having a little difference in expansion coefficients from an active layer, for example, an LN substrate may be used.

The interposed layer 200 is disposed between the LT layer 110 and the LT substrate 400 in a thickness direction. The interposed layer 200 preferably has insulation properties, and is preferably easy to process, for example, easy to make a mirror surface with polishing. The interposed layer 200 is at least one of SiO₂, SiON, or SiN. The interposed layer 200 is not polarized in a state where external voltage has not been applied.

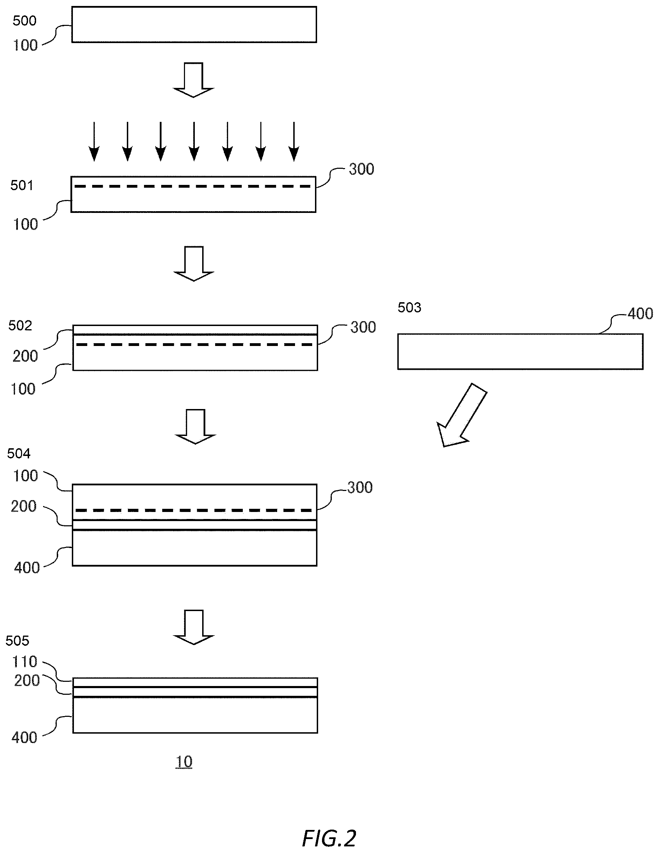

Fig. 2 schematically illustrates each step of a method for producing the composite wafer 10.

500 in Fig. 2 illustrates preparing an LT substrate 100. A part of the LT substrate 100 becomes the LT layer 110 in the composite wafer 10. Thus, the LT substrate 100 may also be regarded as an active substrate. The LT substrate 100 is made by cutting out a plate shape with a thickness of several hundred µm from an LT single-crystal ingot formed by a pulling up method, for example. The LT substrate 100 is subjected to a polarization treatment in which high voltage is applied along a Z-axis of the crystal, and therefore polarization along the Z-axis is caused even without external voltage.

501 in Fig. 2 illustrates implanting an ion into the LT substrate 100. By implanting an ion such as H* from one surface of the LT substrate 100, an ion implantation interface 300 is formed with a thickness of several hundred nm from the one surface. Note that, the one surface is a surface that is closer to the side to be stuck in sticking.

502 in Fig. 2 illustrates forming the interposed layer 200 on the one surface of the LT substrate 100. The interposed layer 200 is formed by either a PVD method or a CVD method, for example.

503 in Fig. 2 illustrates preparing the LT substrate 400 as a supporting substrate. As in the case of the LT substrate 100, the LT substrate 400 is made by cutting out a plate shape with a thickness of several hundred µm from an LT single-crystal ingot formed by a pulling up method, for example. On the other hand, the LT substrate 400 is not subjected to the polarization treatment of the LT substrate 100. The LT substrate 400 is not substantially polarized when external voltage has not been applied.

Note that, a treatment of causing non-polarization may be positively performed on the LT substrate 400. For example, by raising a temperature of the LT substrate 400 to a temperature of a Curie point (phase transition point) or higher, the polarization caused in the LT substrate 400 is destructed. Note that, the Curie point of LT is around 607°C, and the Curie point of LN is around 1160°C.

504 in Fig. 2 illustrates sticking the LT substrate 100 and the LT substrate 400. Before sticking the LT substrate 100 and the LT substrate 400, at least either of the surfaces to be stuck is subjected to an activation treatment. Note that, as in the present embodiment, when the interposed layer 200 is provided on one surface of the LT substrate 100, a sticking surface with the LT substrate 400 is a surface opposite to the LT substrate 100 in the interposed layer 200. Thus, at least either of the sticking surfaces of the interposed layer 200 and the LT substrate 400 is subjected to the activation treatment. The activation treatment includes a plasma treatment.

In the above-described sticking surfaces, the LT substrate 100 and the LT substrate 400 are stuck. In the present embodiment, the LT substrate 100 and the LT substrate 400 are stuck via the interposed layer 200. When at least either of the sticking surfaces has been subjected to the activation treatment, the sticking may be performed at ordinary temperature. Note that, instead of the activation treatment, in the sticking, the sticking may be performed with a high temperature of several hundred degrees Celsius (and optionally also with a high pressure).

505 in Fig. 2 illustrates delaminating the LT substrate 100. In the delaminating of the LT substrate 100, first, temperatures of the LT substrate 100, the interposed layer 200, and the LT substrate 400 which are stuck to one another are raised to, for example, about 200°C or higher. Furthermore, the LT substrate 100 is physically delaminated at the ion implantation interface 300. In this manner, a part of the LT substrate 100 on the sticking surface side remains as the LT layer 110, and the composite wafer 10 is formed.

According to the present embodiment as above, by using substrates having thermal expansion coefficients that are equal or close to each other for the LT substrate 100 which becomes the active layer and the LT substrate 400 which becomes the supporting substrate, a warpage is less likely to be generated at the time of the thermal treatment, and the temperature can be raised to a temperature that enables delamination. Furthermore, since the LT substrate 400 which becomes the supporting substrate is not substantially polarized, a negative effect to the LT layer 110 which is the active layer can be avoided.

### EXAMPLE 1

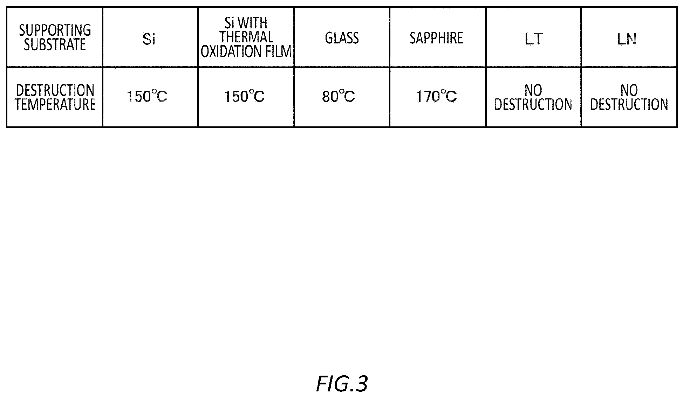

A SiO₂ film was formed for 700 nm by a PVD (sputtering) method on a 42° Y-cut LT 100 mmϕ wafer (with polarization) having a thickness of 0.35 mm, and polishing was performed to 500 nm. This wafer was stuck to various supporting substrates after being subjected to a surface treatment by a plasma activation method, and the temperature was raised. Fig. 3 shows destruction temperatures at that time. A destruction occurred at a low temperature when there is a large difference in expansion coefficients, and a destruction did not occur when LT or LN which has no difference in expansion coefficients was used for the supporting substrate. The use of LT or LN as the supporting substrate is considered to be effective in terms of prevention of a crack in the substrate.

### EXAMPLE 2

A SiO₂ film was formed for 700 nm by the PVD (sputtering) method on a 160° Y-cut LN 100 mmϕ wafer (with polarization) having a thickness of 0.35 mm, and polishing was performed to 500 nm. This wafer was stuck to various supporting substrates after being subjected to a surface treatment by a plasma activation method, and the temperature was raised. The results were the same as Example 1.

### EXAMPLE 3

H⁺ ions were implanted with 100 keV in a dose amount of 7.5e16 atoms/cm² into a 42° Y-cut LT 100 mmϕ wafer (with polarization) having a thickness of 0.35 mm which becomes the active layer. Then, a film of SiO₂ was formed by the PVD (sputtering) method, and polishing was performed. This wafer was stuck to various supporting substrates after being subjected to a surface treatment by the plasma activation method, and the temperature was raised to 180°C. Then, delamination was performed along an implantation interface with a SiGen method (mechanical delamination method), and polishing was performed on the surface to make the thickness of LT to 500 nm, followed by a thermal treatment of 550°C to obtain a composite wafer.

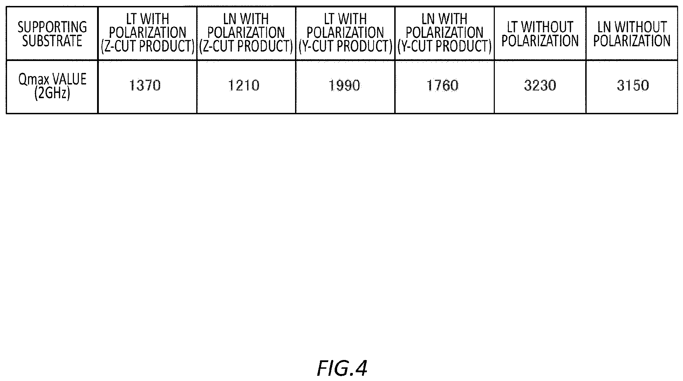

A resonator was created for these composite wafers, and a Qmax value was measured near 2GHz. A Q value is a sharpness of a signal peak, and a value thereof is an index for measuring performance of a device. The results are shown in Fig. 4. From these results, it became clear that a supporting wafer using LT or LN without polarization has best characteristics.

### EXAMPLE 4

The same experiment as Example 3 was conducted by using a 160° Y-cut LN 100 mmϕ wafer (with polarization) having a thickness of 0.35 mm which becomes an active layer. The temperature was raised to 450°C before delamination. The results showed a tendency similar to Example 3.

### EXAMPLE 5

The results were almost the same even when the film of the interposed layer was formed by a CVD (chemical vapor deposition) method, or the material of the interposed layer was changed to SiON or SiN, in Example 1. It became clear that the present invention is not dependent on the film formation method or the material of the interposed layer.

While the present invention has been described by way of the embodiments, the technical scope of the present invention is not limited to the scope described in the above-described embodiments. It is apparent to persons skilled in the art that various alterations or improvements can be made to the above-described embodiments. It is also apparent from the description of the claims that embodiments added with such alterations or improvements are included in the scope of the claims.

The operations, procedures, steps, stages, or the like of each process performed by a device, system, program, and method shown in the claims, embodiments, or drawings can be performed in any order as long as the order is not indicated by "prior to," "before," or the like and as long as the output from a previous process is not used in a later process. Even if the process flow is described using phrases such as "first" or "next" in the claims, embodiments, or drawings, it does not necessarily mean that the process must be performed in this order.

### EXPLANATION OF REFERENCES

10: composite wafer;
100: LT substrate;
110: LT layer;
200: interposed layer;
300: ion implantation interface;
400: LT substrate.

## Claims

1. A method for producing a composite wafer (10), comprising:
preparing a supporting substrate (400) which is either lithium tantalate or lithium niobate;
preparing an active substrate (100) which is either lithium tantalate or lithium niobate and is polarized;
generating an interface (300) by implanting an ion into the active substrate (100);
sticking the supporting substrate (400) and the active substrate (100);
raising temperatures of the supporting substrate (400) and the active substrate (100) which are stuck to each other; and
delaminating the active substrate (100) at the interface (300), wherein
the method further comprises forming an interposed layer (200) on at least either of surfaces of the supporting substrate (400) and the active substrate (100) to be stuck to each other, before the sticking,
in the sticking, the interposed layer (200) is stuck to another of the surfaces of the supporting substrate (400) and the active substrate (100) to be stuck to each other, and
the interposed layer (200) comprises at least one of SiO₂, SiON, or SiN;
**characterized in that**
the supporting substrate (400) is substantially not polarized;
wherein the method further comprises:
subjecting at least either of surfaces of the supporting substrate (400) and the active substrate (100) to be stuck to each other to an activation treatment, before the sticking, wherein the activation treatment comprises a plasma treatment.

2. The method for producing the composite wafer (10) according to claim 1, wherein
the interposed layer (200) has insulation properties.

3. The method for producing the composite wafer (10) according to claim 1, wherein
the interposed layer (200) is formed by either a PVD method or a CVD method.

4. The method for producing the composite wafer (10) according to claim 1 or 2, wherein:
the preparing the supporting substrate comprises performing a polarization step of the supporting substrate to be non-polarized.

5. The method for producing the composite wafer (10) according to claim 4, wherein: performing the polarization step of the supporting substrate to be non-polarized by raising a temperature of the supporting substrate equal to or higher than a Curie point.

## Patentansprüche

1. Fertigungsverfahren für einen Verbundwafer (10), umfassend:
Vorbereiten eines Trägersubstrats (400), das entweder aus Lithiumtantalat oder Lithiumniobat besteht;
Vorbereiten eines aktiven Substrats (100), das entweder aus Lithiumtantalat oder Lithiumniobat besteht und polarisiert ist;
Erzeugen einer Grenzfläche (300) durch Implantieren eines Ions in das aktive Substrat (100);
Verkleben des Trägersubstrats (400) und des aktiven Substrats (100);
Erwärmen des Trägersubstrats (400) und des aktiven Substrats (100), die miteinander verklebt sind; und
Ablösen des aktiven Substrats (100) an der Grenzfläche (300), wobei
das Verfahren ferner das Aufbringen einer Zwischenschicht (200) auf mindestens eine der Oberflächen des Trägersubstrats (400) und des aktiven Substrats (100) umfasst, die miteinander verklebt werden sollen, vor dem Verkleben,
beim Verkleben die Zwischenschicht (200) auf eine andere der beiden Oberflächen des Trägersubstrats (400) und des aktiven Substrats (100) aufgebracht wird, die miteinander verklebt werden sollen, und
die Zwischenschicht (200) mindestens eines der Materialien SiO₂, SiON oder SiN umfasst;
**dadurch gekennzeichnet, dass**
das Trägersubstrat (400) im Wesentlichen unpolarisiert ist;
wobei das Verfahren ferner umfasst:
wobei mindestens eine der Oberflächen des Trägersubstrats (400) und des aktiven Substrats (100), die miteinander verklebt werden sollen, vor dem Verkleben einer Aktivierungsbehandlung unterzogen wird, wobei die Aktivierungsbehandlung eine Plasmabehandlung umfasst.

2. Fertigungsverfahren für den Verbundwafer (10) nach Anspruch 1, wobei
die Zwischenschicht (200) Isolationseigenschaften aufweist.

3. Fertigungsverfahren für den Verbundwafer (10) nach Anspruch 1, wobei
die Zwischenschicht (200) entweder mittels eines PVD-Verfahrens oder eines CVD-Verfahrens hergestellt wird.

4. Fertigungsverfahren für den Verbundwafer (10) nach Anspruch 1 oder 2, wobei:
das Vorbereiten des Trägersubstrats das Durchführen eines Polarisationsschritts an dem Trägersubstrat, das unpolarisiert sein soll, umfasst,.

5. Fertigungsverfahren für den Verbundwafer (10) nach Anspruch 4, wobei:
Durchführen des Polarisationsschritts, bei dem das Trägersubstrat, das unpolarisiert sein soll, indem die Temperatur des Trägersubstrats auf einen Wert angehoben wird, der dem Curie-Punkt entspricht oder darüber liegt.

## Revendications

1. Procédé de production d'une tranche composite (10), comprenant :
la préparation d'un substrat de support (400) qui est soit tantalate de lithium ou niobate de lithium;
la préparation d'un substrat actif (100) qui est soit tantalate de lithium ou niobate de lithium, et qui est polarisé;
la génération d'une interface (300) par implantation d'un ion dans le substrat actif (100) ;
le collage du substrat de support (400) et du substrat actif (100);
l'augmentation des températures du substrat de support (400) et du substrat actif (100) qui sont collés l'un à l'autre; et
la délamination du substrat actif (100) au niveau de l'interface (300), dans lequel :
le procédé comprend en outre la formation d'une couche interposée (200) sur au moins une surface parmi les surfaces du substrat de support (400) et du substrat actif (100) destinées à être collées l'une à l'autre, avant le collage,
lors du collage, la couche interposée (200) est collée à l'autre des surfaces du substrat de support (400) et du substrat actif (100) destinées à être collées l'une à l'autre, et
la couche interposée (200) comprend au moins un parmi SiO₂, SiON et SiN ;
**caractérisé en ce que** :
le substrat de support (400) est sensiblement non polarisé ;
dans lequel le procédé comprend en outre :
la soumission d'au moins une surface parmi les surfaces du substrat de support (400) et du substrat actif (100), destinées à être collées l'une à l'autre, à un traitement d'activation, avant le collage, et dans lequel le traitement d'activation comprend un traitement par plasma.

2. Procédé de production de la tranche composite (10) selon la revendication 1, dans lequel
la couche interposée (200) présente des propriétés isolantes.

3. Procédé de production de la tranche composite (10) selon la revendication 1, dans lequel
la couche interposée (200) est formée soit par un procédé PVD ou par un procédé CVD.

4. Procédé de production de la tranche composite (10) selon la revendication 1 ou 2, dans lequel
la préparation du substrat de support comprend la réalisation d'une étape de polarisation du substrat de support de manière à le rendre non polarisé.

5. Procédé de production de la tranche composite (10) selon la revendication 4, dans lequel
l'étape de polarisation du substrat de support pour le rendre non polarisé est réalisée en augmentant la température du substrat de support de telle sorte qu'elle soit égale ou supérieure à un point de Curie.
